# EUROPEAN PATENT APPLICATION

(11) **EP 2 500 735 A1**
(43) Date of publication of application: **19.09.2012**
(21) Application number: 12158926.1
(22) Date of filing: 09.03.2012
(51) Int. Cl.: G01R 11/04, G01R 11/24

(54) **Secure seal for utility meter**

(30) Priority: 16.03.2011 US 201113048927
(71) Applicant: General Electric Company, Schenectady, NY 12345 (US)
(72) Inventor: Nahar, Rathindra, Atlanta, GA 30339 (US)
(74) Representative: Picker, Madeline Margaret

(57) **Abstract**

A utility meter assembly (100, 200) that provides a tamper proof seal for a utility meter is disclosed. The utility meter assembly (100, 200) according to embodiments of this invention includes a base plate (102, 202) adapted for mounting a utility meter thereon, a cover (104, 204) configured to rotationally interlock with the base plate (102, 202), and a tamper indicator linking the base plate (102, 202) and the cover (104, 204) in the interlocked position. The tamper indicator is configured to indicate tampering in response to a tamper condition, including the cover (104, 204) being rotated with respect to the base, away from the interlocked position, or the tamper indicator being removed to unlink the base plate (102, 202) and the cover (104, 204). The assembly further ensures that the cover (104, 204) cannot be partially pried off the base plate (102, 202) without at least a portion of the cover (104, 204) or the base plate (102, 202) being structurally deformed.

## Description

### BACKGROUND OF THE INVENTION

The subject matter disclosed herein relates generally to meter technology, and more particularly, to an assembly for a utility meter including a cover and a base plate interlocked together such that the cover cannot be removed or partially pried open from the base plate without rotating and breaking a tamper indicator.

Current designs of utility meter assemblies include a base, with a utility meter thereon, and a cover that is placed over the utility meter and base. However, current designs include a cover that is too flexible and can be pried open with a device like a screwdriver. Since the cover can be pried open without permanent damage, the electrical components of the utility meter can be accessed without a utility company's knowledge. Accessing the utility meter could by-pass the metrological seal, thereby compromising the integrity of the utility meter and allowing someone to tamper with the utility meter.

### BRIEF DESCRIPTION OF THE INVENTION

A utility meter assembly that provides a tamper proof seal for a utility meter is disclosed. The utility meter assembly according to embodiments of this invention includes a base plate adapted for mounting a utility meter thereon, a cover configured to rotationally interlock with the base plate, and a tamper indicator linking the base plate and the cover in the interlocked position. The tamper indicator is configured to indicate tampering in response to a tamper condition, including the cover being rotated with respect to the base, away from the interlocked position, the tamper indicator being removed to unlink the base plate and the cover, and/or the cover being at least partially pried off the base plate. In one embodiment, the tamper indicator comprises a mechanical element adapted for insertion through the base plate and the cover in the interlocked position. The utility meter assembly according to embodiments of this invention ensures that the cover can only be removed from the base plate in the interlocked position by rotating the cover thus breaking the tamper indicator, or removing the tamper indicator then rotating the cover. Either way, the tamper indicator will indicate that the cover has been removed. The assembly further ensures that the cover cannot be partially pried off the base plate to allow access to the utility meter within without at least a portion of the cover or base plate being deformed or broken.

A first aspect of the invention provides an assembly for a utility meter, the assembly comprising: a base plate adapted for mounting a utility meter thereon; a cover configured to rotationally interlock with the base plate; and a tamper indicator adapted for linking the base plate and the cover in the interlocked position, wherein the tamper indicator is configured to indicate tampering in response to a tamper condition.

### BRIEF DESCRIPTION OF THE DRAWINGS

These and other features of this invention will be more readily understood from the following detailed description of the various aspects of the invention taken in conjunction with the accompanying drawings that depict various embodiments of the invention, in which:
FIG. 1 shows an isometric back view of a utility meter assembly according to an embodiment of the invention;
FIG. 2 shows an exploded back view of a base plate and a cover of a utility meter assembly in an interlocked position according to an embodiment of the invention;
FIG. 3 shows an exploded cross-sectional view of a base plate and a cover of a utility meter assembly in an interlocked position according to an embodiment of the invention;
FIG. 4 shows an exploded cross-sectional view of a base plate and a cover of a utility meter assembly in an interlocked position according to an embodiment of the invention;
FIG. 5 shows an exploded isometric view of a base plate for a utility meter assembly according to an embodiment of the invention;
FIG. 6 shows an exploded isometric view of a cover for a utility meter assembly according to an embodiment of the invention;
FIG. 7 shows a cross-sectional view of a mechanical element for use in connection with a utility meter assembly according to an embodiment of the invention; and
FIG. 8 shows an exploded cross-sectional view of one end of a mechanical element for use in connection with a utility meter assembly according to an embodiment of the invention.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION OF EMBODIMENTS OF THE INVENTION

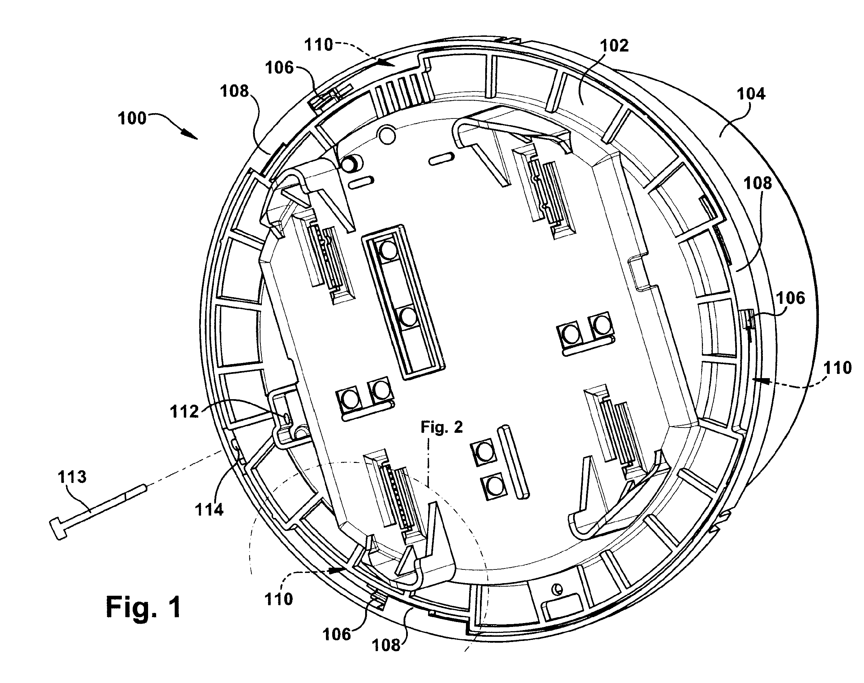

Turning to FIG. 1, an assembly 100 for a utility meter (not shown) according to an embodiment of this invention is shown. Assembly 100 includes a base plate 102 which is adapted for mounting the utility meter thereon. The utility meter may comprise an electrical meter, a water meter, a gas meter or any other form of utility meter as is known in the art. Assembly 100 further includes a cover 104 configured to rotationally interlock with base plate 102. The manner in which cover 104 and base plate 102 rotationally interlock is discussed in more detail below. Assembly 100 further includes a tamper indicator linking base plate 102 and cover 104. In one embodiment, tamper indicator comprises a mechanical element 113 adapted for insertion through base plate 102 and cover 104, when base plate 102 and cover 104 are in an interlocked position, to link base plate 102 and cover 104. Assembly 100 has the technical advantage that once in an interlocked position, with tamper indicator in place (e.g., with mechanical element 113 inserted), cover 104 can only be removed from base plate 102 by rotating cover 104 and breaking or removing tamper indicator (e.g., mechanical element 113).

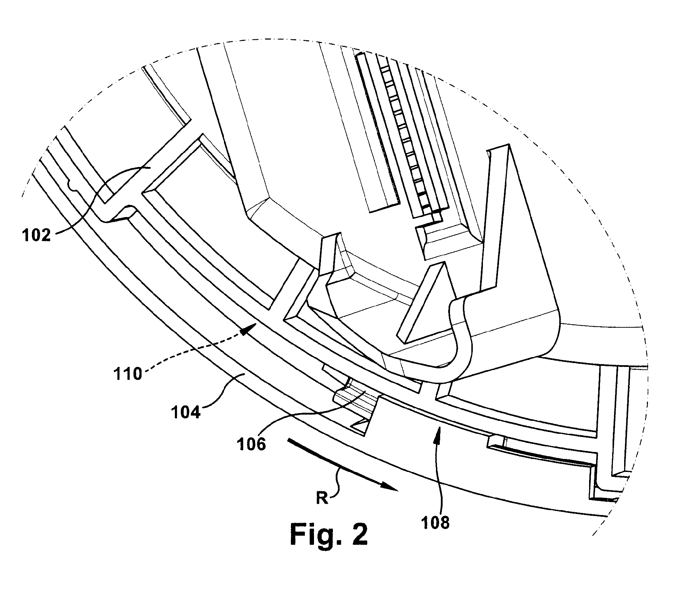

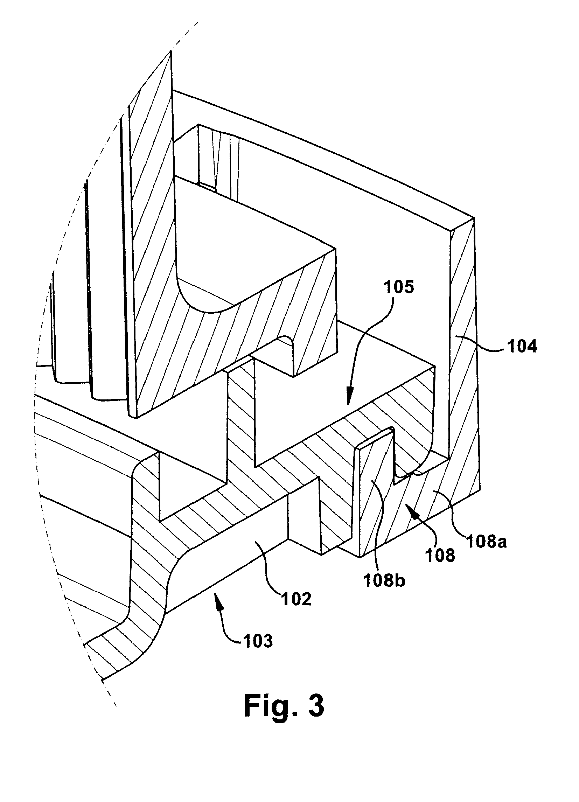

A first embodiment, shown in FIGS. 1-3, illustrates a first manner in which cover 104 can be rotationally interlocked with base plate 102. As shown in close-up FIG. 3, base plate 102 has a front side 105 adapted for mounting a utility meter thereon, and a back side 103, opposite front side 105. As shown in FIGS. 1 and 2, back side 103 includes at least one circumferential groove 106 proximate to an outer edge of base plate 102. In one embodiment, circumferential groove 106 forms a U-shaped opening near outer edge of base plate 102. Back side 103 further includes at least one circumferential opening 110 adjacent to each circumferential groove 106. Circumferential openings 110 can comprise cut-outs along the outer edge of base plate 102 (as best shown in FIG. 2), or can comprise slits or partial slits just inside the outer edge of base plate 102.

Cover 104 of assembly 100 includes at least one bent tab 108 proximate to an outer edge of cover 104. As best shown in FIG. 3, bent tabs 108 each have a first portion 108a extending radially inward and a second portion 108b substantially perpendicular to first portion 108a. As such, and as discussed in more detail below, bent tabs 108 are configured to partially wrap around back side 103 of base plate 102. In one embodiment, bent tabs 108 form U-shaped protrusions extending from cover 104.

To rotationally interlock base plate 102 and cover 104, cover 104 is placed on base plate 102 such that each bent tab 108 extends into a corresponding circumferential opening 110 in base plate 102. Then, as cover 104 is rotated by a user, each bent tab 108 is configured to rotationally engage a circumferential groove 106 adjacent to openings 110. In other words, each bent tab 108 is slid into a groove 106 as cover 104 is rotated. In this way, cover 104 will be rotationally interlocked with base plate 102 as each bent tab 108 is rotated into a groove 106.

In one embodiment, a depth of groove 110 can varied, i.e., a bottom surface of groove 110 can be sloped, such that a groove 110 becomes progressively deeper from a first end proximate to opening 110 and a second end opposite the first end. In other words, circumferential groove 110 is deeper at the second end than at the first end. Additionally, a corresponding bent tab 108 can have a variable height, i.e., a surface of second portion 108b can be sloped, to correspond with the sloped surface of the groove 110.

In one embodiment, cover 104 includes three bent tabs 108, spaced evenly around a circumference of the outer edge of cover 104, while base plate 102 includes three corresponding grooves 106 (and openings 110), spaced evenly around a circumference of the outer edge of base plate 102. For example, three bent tabs 108 can be spaced approximately 120 degrees apart from each other around the circumference of the outer edge of cover 104, and three grooves 106 can be spaced approximately 120 degrees apart from each other around the circumference of the outer edge of base plate 102.

As shown in FIG. 1, base plate 102 can further include at least one radially extending base plate hole 112, and cover 104 can include at least one radially extending cover hole 114. When cover 104 and base plate 102 are interlocked together, i.e., in an interlocked position, base plate hole(s) 112 and cover hole(s) 114 are substantially lined up and a tamper indicator can be used to link base plate 102 and cover 104, e.g., mechanical element 113 can be inserted through base plate hole 112 and cover hole 114.

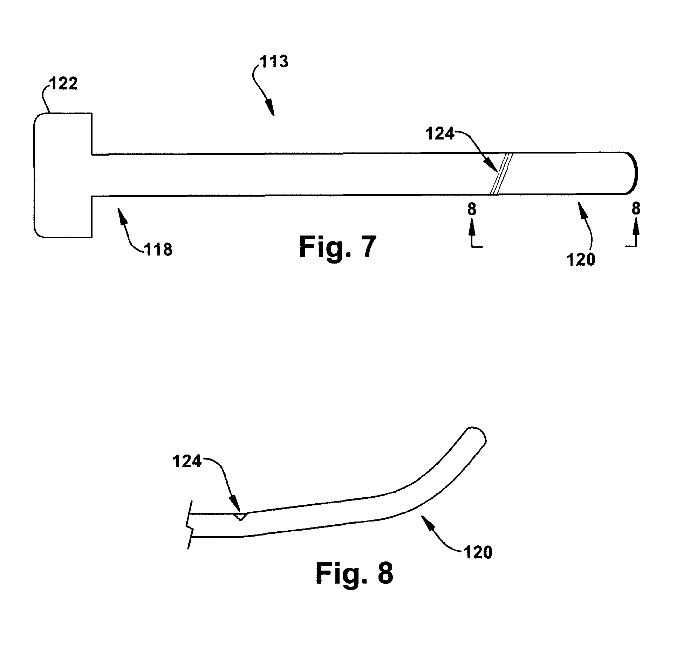

In one embodiment, mechanical element 113 can be formed of a material that is stiff enough to mechanically be inserted through cover 104 and base plate 102, while also weak enough to be able to be broken by a user, either when mechanical element 113 is removed, or when a user rotates cover 104 with respect to base plate 102, away from the interlocked position, to attempt to remove cover 104. In one embodiment, shown in FIG. 7, a substantially straight mechanical element 113, for example, an aluminum bar, is used. As shown in FIG. 7, mechanical element 113 has a first end 118 and a second end 120. A user can grasp first end 118 and insert second end 120 into holes 112, 114 (FIG. 1). In the embodiment shown in FIG. 7, first end 118 includes a head 122, but it is understood that head 122 is optional. In this embodiment, mechanical element 113 further includes at least one scored area 124. As understood by one in the art, scored area 124 comprises a weakened area of mechanical element 113.

In operation, once cover 104 and base plate 102 are interlocked together, i.e., in an interlocked position, and base plate hole(s) 112 and cover hole(s) 114 are substantially lined up, a user can insert mechanical element 113 (second end 120 first) through holes 112, 114. Once mechanical element 113 is through holes 112, 114, the user can bend second end 120 of mechanical element 113 as shown in FIG. 8, or in another embodiment, holes 112, 114 can be shaped such that mechanical element is bent upon insertion. Because mechanical element 113 is scored, it will tend to bend at scored area 124. Mechanical element 113 can be bent at any desired angle, for example, mechanical element 113 can be only slightly bent, i.e., approximately 10 degrees to 30 degrees, can be bent at approximately 90 degrees, or can be bent back onto itself, i.e., approximately 90 degrees to 180 degrees. Due to the material properties of mechanical element 113, for example, the strength and elasticity of aluminum, once mechanical element 113 is bent again (i.e., bent back) it will shear or break. Therefore, once a user bends mechanical element 113, it cannot be unbent, or bent again, without breaking. Because mechanical element 113 is bent after being inserted in holes 112, 114, if mechanical element 113 is pulled out of holes 112, 114, it will need to straighten out, i.e., bend again in the reverse direction in which it was originally bent. Re-bending mechanical element 113 in this way will break mechanical element 113. Similarly, rotating cover 104 without removing mechanical element 113 will break mechanical element 113. In this way, it will be clear to a user whether cover 104 has been removed, or attempted to be removed, from base plate 102 because the tamper indicator will indicate tampering, i.e., mechanical element 113 will be broken.

It is also understood that while an aluminum bar shaped mechanical element 113 is shown in FIGS. 7 and 8, mechanical element 113 can comprise any element able to be inserted through base plate hole 112 and cover hole 114, for example, a wire, a bar, or a pin. For example, a wire can be used, and once inserted, the wire could be crimped or twisted, such that it cannot be removed without breaking the wire.

In another embodiment, the tamper indicator can comprise tape used to seal the joint between cover 104 and base plate 102 (either the entire joint, or a portion of the joint), thereby linking cover 104 and base plate 102. In this embodiment, tamper evident security tape as known in the art can be used, such that if tape is removed, the tape is either destroyed or tamper evidence is shown, such as leaving words or symbols on assembly 100 or on the security tape itself.

As discussed above, in operation, to secure cover 104 to base plate 102 (with a utility meter thereon), a user places cover 104 on base plate 102 (such that bent tabs 108 extend into openings 110) and then rotates cover 104 with respect to base plate 102, thus sliding bent tabs 108 into grooves 106. In this way, cover 104 is rotationally interlocked with base plate 102. Then, with cover 104 and base plate 102 in an interlocked position, a tamper indicator (e.g., mechanical element 113 or tamper evident tape) is utilized to link base plate 102 and cover 104. The tamper indicator is configured to indicate tampering in response to a tamper condition. This tamper condition can comprise cover 104 being rotated with respect to base plate 102, away from the interlocked position, the tamper indicator being removed, and/or if cover 104 is attempted to be partially pried off base plate 102. In response to any of these conditions, the tamper indicator will indicate tampering.

In one embodiment, once interlocked, base plate hole 112 and cover hole 114 can be lined up, and a user can insert a mechanical element 113 through holes 112, 114, linking cover 104 and base plate 102. Therefore, if a user needs to access the utility meter within assembly 100, a user must rotate cover 104 with respect to base plate 102, thus breaking mechanical element 113, or remove mechanical element 113 (which in turn will break mechanical element 113), and then rotate cover 104 with respect to base plate 102 away from the interlocked position. Either way, it is clear whether anyone has accessed the utility meter, with or without permission, since the broken or tampered-with tamper indicator will alert a user that cover 104 has been removed (or partially removed) from base plate 102.

In addition, the interlocked connection between base plate 102 and cover 104 prevents a user from prying open cover 104. In other words, the interlocked connection prevents separation along a circumference of cover 104 and base plate 102, for example, preventing a user from attempting to create a space between cover 104 and base plate 102 (e.g., by inserting a tool such as a screwdriver or wire) to access the uility meter therein. The interlocked connection ensures that if a user attempts to even partially pry cover 104 off base plate 102, at least one of cover 104 or base plate 102 will be structurally deformed, or broken. Specifically, tabs 108 will be deformed or broken if cover 104 is partially pried off base plate 102, and therefore the broken or deformed tabs 108 would alert a user that the assembly was tampered with. In addition, the tamper indicator can also be configured to indicate tampering if cover 104 is at least partially pried off base plate 102.

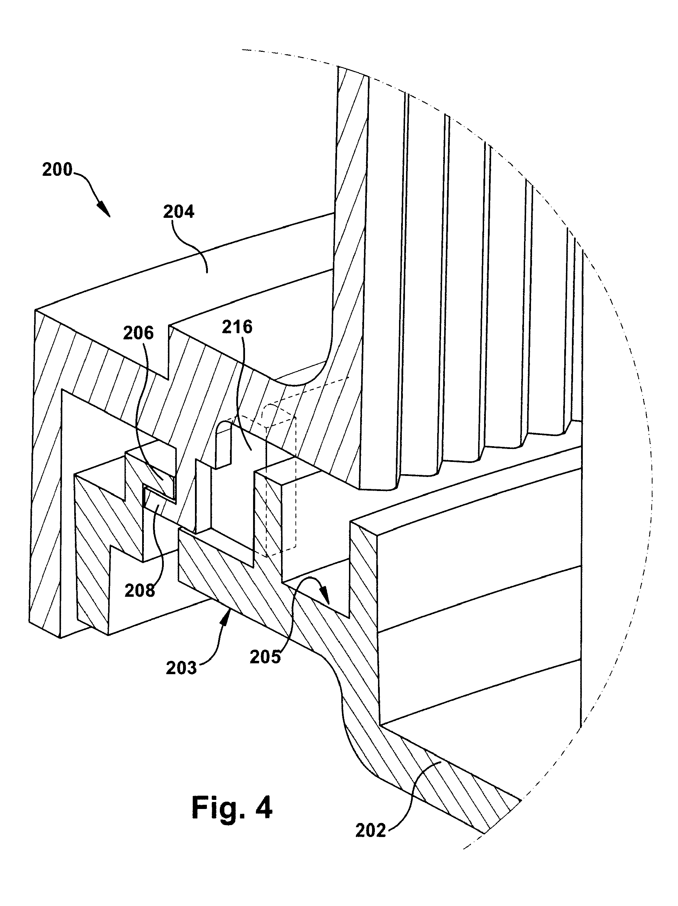

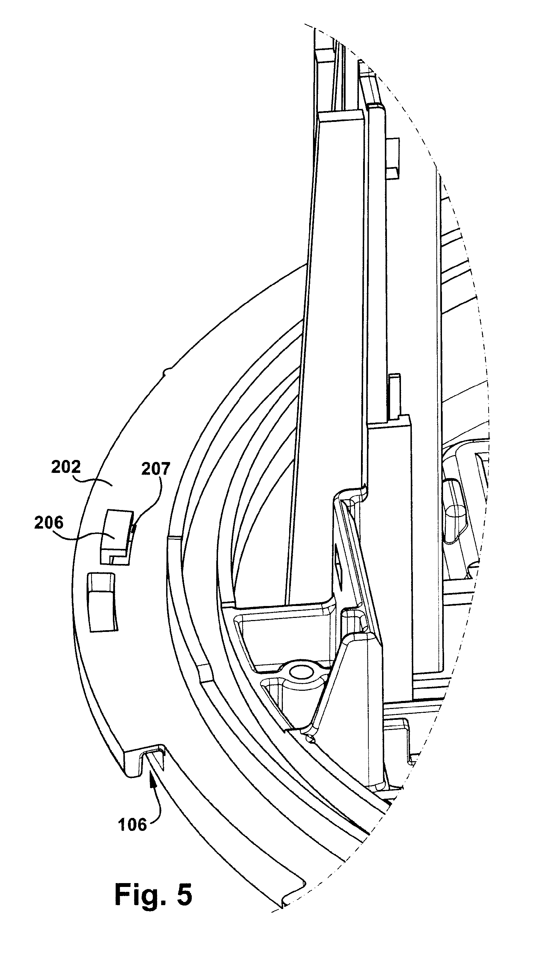

In a second embodiment, shown in FIGS. 4-6, another manner of rotationally interlocking a base plate 202 and a cover 204 is shown. In this embodiment, assembly 200 includes tabs and grooves, as in the embodiment shown in FIGS. 1-3, but in this embodiment, the interlock between cover 204 and base plate 202 happens on the front side of base plate 202, in contrast to the back side of base plate 102 as in FIGS. 1-3. In this embodiment, as shown in FIG. 4, base plate 202 includes a front side 205 adapted for mounting a utility meter thereon, and a back side 203 opposite front side 205, and base plate front side 205 further includes at least one base plate bent tab 206 extending outward from an outer edge of base plate 202. As shown in close-up view in FIG. 5, each base plate bent tab 206 is bent such that a groove 207 is formed between each base plate bent tab 206 and base plate 202.

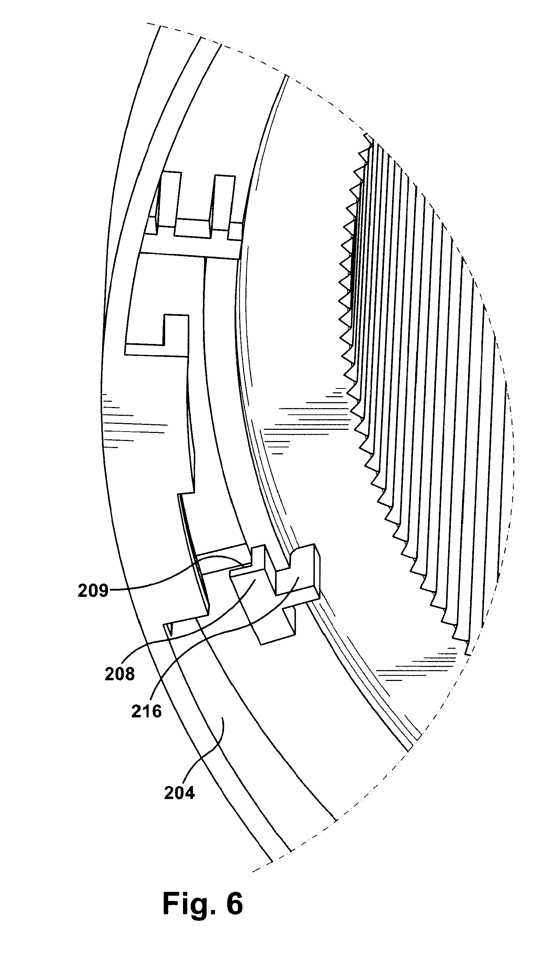

In addition, in this embodiment, as shown in FIG. 6, cover 204 includes at least one cover bent tab 208 extending outward from an outer edge of cover 204. As shown in FIG. 6, each cover bent tab 208 is bent such that a groove 209 is formed between cover 204 and each cover bent tab 208. As shown in FIG. 4, each cover bent tab 208 is configured to mate with a corresponding base plate bent tab 206, i.e., cover bent tabs 208 are configured to slide into groove 207 formed by base plate tabs 206. Therefore, in operation, cover 204 is interlocked with base plate 202 by placing cover 204 over base plate 202, rotating cover 204 with respect to base plate 202, and in response to the rotation, each cover bent tab 208 slides into groove 207 formed by each corresponding base plate bent tab 206, interlocking cover 204 and base plate 202. Again, as in the embodiment shown in FIGS. 1-3, once cover 204 and base plate 202 are interlocked, a tamper indicator can be used to link cover 204 and base plate 202. The tamper indicator is again configured to indicate tampering in response to a tamper condition, such as cover 204 being rotated with respect to base plate 202, away from the interlocked position, the tamper indicator being removed, and/or if cover 204 is attempted to be partially pried off base plate 202. Again, as with the first embodiment described herein, in the interlocked postion, if someone attempts to pry cover 204 off base plate 202, tabs 206, 208 will be deformed or broken, and therefore the broken or deformed tabs 206, 208 would alert a user that the assembly was tampered with.

In one embodiment, tamper indicator comprises a mechanical element 113 (FIG. 1), inserted through cover hole 114 and base plate hole 112 (shown in FIG. 1) which are substantially lined up after cover 204 is interlocked with base plate 202. In addition, in this embodiment, as shown in FIG. 6, cover 204 can further include at least one supporting rib 216 adjacent to each cover bent tab 208. Supporting ribs 216 are configured to limit motion of each cover bent tab 208 in a radial direction. In this way, cover bent tabs 208 will not be bent inward if a user attempts to pry open cover 204.

In one embodiment, shown in FIGS. 4-6, base plate bent tab 206 and cover bent tab 208 are each an L-shaped tab, but it is understood that both bent tabs 206, 208 can be any shape adapted to mate together.

In another embodiment, base plate 102, 202 and cover 104, 204 can be rotationally interlocked using threads. In this embodiment, base plate 102, 202 can include threads along its outer edge, and cover 104, 204 can include corresponding threads, such that cover 104, 204 can be screwed on to base plate 102, 202 to rotationally interlock base plate 102, 202 and cover 104, 204. Again, as with previous embodiments, a tamper indicator is used, along with the threads, such that cover 104, 204 cannot be removed without rotating, thereby breaking or removing tamper indicator 113. In other words, tamper indicator (e.g., mechanical element 113 or tamper evident tape) is configured to indicate tampering if cover 104, 204 is unscrewed from base plate 102, 202, or cover 104, 204 is partially pried off base plate 102, 202.

It is also understood that in all embodiments discussed herein and shown in FIGS. 1-6, the various elements on base plates 102, 202 and covers 104, 204 can be reversed. For example, in the first embodiment, cover 104 could include grooves 106, while base plates 102 could include bent tabs 108. It is also understood that while specific shaped bent tabs and grooves are shown and discussed herein, one of ordinary skill in the art would understand that different shapes and sized tabs and grooves can be utilized. For example, bent tabs 108 and grooves 106 are shown forming a U-shaped protrusions and grooves, but any shape tabs can be used, e.g., to form protrusions or grooves that are V-shaped, T-shaped, etc.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. It is further understood that the terms "front" and "back" are not intended to be limiting and are intended to be interchangeable where appropriate.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. An assembly (100, 200) for a utility meter, the assembly (100, 200) comprising:
a base plate (102, 202) adapted for mounting a utility meter thereon;
a cover (104, 204) configured to rotationally interlock with the base plate (102, 202); and
a tamper indicator adapted for linking the base plate (102, 202) and the cover (104, 204) in the interlocked position, wherein the tamper indicator is configured to indicate tampering in response to a tamper condition.

2. The assembly (100, 200) of claim 1, wherein the tamper condition is selected from the group consisting of:
the cover (104, 204) being rotated with respect to the base, away from the interlocked position; and
the tamper indicator being removed to unlink the base plate (102, 202) and the cover (104, 204).

3. The assembly (100, 200) of claim 1 or claim 2, wherein the base plate (102, 202) includes a front side (105, 205) adapted for mounting the utility meter thereon, and a back side, opposite the front side (105, 205), wherein the back side (103, 203) includes at least one circumferential groove (106) proximate to an outer edge of the base plate (102) and preferably at least one circumferential opening (110) adjacent to the at least one circumferential groove (106).

4. The assembly (100, 200) of claim 3, wherein the cover (104) includes at least one bent tab (108) proximate to an outer edge of the cover (104), wherein the at least one bent tab (108) has a first portion (108a) extending radially inward and a second portion (108b) substantially perpendicular to the first portion (108a).

5. The assembly (100, 200) of claim 4, wherein the at least one bent tab (108) is configured to extend into the at least one circumferential opening (110) in the base plate (102), and the at least one bent tab (108) is configured to rotationally engage the at least one circumferential groove (106).

6. The assembly (100, 200) of claim 5, wherein the at least one circumferential groove (106) has a first end proximate to the at least one circumferential opening (110), and a second end opposite the first end, wherein a bottom surface of the at least one circumferential groove (106) is sloped such that the at least one circumferential groove (106) is deeper at the second end than at the first end, and preferably a surface of the second portion of the at least one bent tab (108) is sloped to correspond with the sloped surface of the at least one circumferential groove (106).

7. The assembly (100, 200) of claim 5, wherein the at least one circumferential groove (106) comprises three circumferential grooves (106), spaced approximately 120 degrees apart around a circumference of the outer edge of the base plate (102), and the at least one bent tab (108) comprises three bent tabs (108), spaced approximately 120 degrees apart around a circumference of the outer edge of the cover (104).

8. The assembly (100, 200) of any one of the preceding claims, wherein the tamper indicator comprises a mechanical element (113) adapted for insertion through the base plate (102, 202) and the cover (104, 204) in an interlocked position, and wherein the mechanical element (113) indicates tampering by breaking.

9. The assembly (100, 200) of claim 8, wherein the base plate (102, 202) further includes a radially extending base plate hole (112), and wherein the cover (104, 204) further includes a radially extending cover hole (114), and wherein in the interlocked position, the base plate hole (112) and the cover hole (114) are substantially lined up to receive the mechanical element (113) therethrough, and wherein, preferably, in response to the mechanical element (113) being inserted through the base plate hole (112) and the cover hole (114), at least one end of the mechanical element (113) is bent, and the mechanical element (113) cannot be removed without breaking the mechanical element (113).

10. The assembly of claim 7, wherein the mechanical element (113) includes a weakened portion, and in response to being inserted through the base plate hole (112) and the cover hole (114), the at least one end of the mechanical element (113) is bent at the weakened portion.

11. The assembly (100, 200) of claim 8, 9 or 10, wherein the mechanical element (113) comprises one of the following: a wire, a bar, and a pin.

12. The assembly (100, 200) of any one of the preceding claims, wherein the interlocked position prevents separation along a circumference of the cover (104, 204) and the base plate (102, 202), and in response to the cover (104, 204) being at least partially pried off the base plate (102, 202), at least one of the cover (104, 204) or the base plate (102, 202) will be structurally deformed.

13. The assembly (100, 200) of any one of the preceding claims, wherein the base plate (202) includes a front side (205) adapted for mounting the utility meter thereon, and a back side, opposite the front side (205), wherein the front side (205) includes at least one base plate bent tab (206) proximate to an outer edge of the front side (205), and wherein the cover (204) preferably includes at least one cover bent tab (208) proximate to an outer edge of the cover (204), and wherein the at least one cover bent tab (208) is configured to mate with the at least one base plate bent tab (206) in response to the cover (204) and the base plate (202) being in the interlocked position.

14. The assembly of claim 13, wherein the cover (104, 204) further includes at least one supporting rib (216) adjacent to the at least one cover bent tab (208), wherein the at least one supporting rib (216) is configured to limit motion of the at least one cover bent tab (208) in a radial direction.

15. The assembly of any one of the preceding claims, wherein the base plate (102, 202) includes base plate threads, and an outer edge of the cover (104, 204) includes cover threads, wherein the base plate threads are configured to mate with the cover threads to rotationally interlock the base plate (102, 202) with the cover (104, 204).
